# EUROPEAN PATENT APPLICATION

(11) **EP 4 667 956 A1**
(43) Date of publication of application: **24.12.2025**
(21) Application number: 24882955.8
(22) Date of filing: 16.10.2024
(51) Int. Cl.: G01R 31/392, G01R 31/367, G01R 31/396, G01R 31/385, G01R 31/52, H01M 10/48

(54) **APPARATUS AND METHOD FOR MANAGING BATTERY**

(30) Priority: 26.10.2023 KR 20230144293
(71) Applicant: LG Energy Solution, Ltd., Seoul 07335 (KR)
(72) Inventor: SONG, Keehoon, Daejeon 34122 (KR)
(74) Representative: Plasseraud IP
(86) International application number: PCT/KR2024/096366
(87) International publication number: WO 2025/089929

(57) **Abstract**

Disclosed is a battery management apparatus according to embodiments and experimental examples of the present invention, which includes an instruction to detect occurrence of an abnormality in the battery system; an instruction to determine a specific battery group in which the abnormality has occurred depending on whether balancing has been performed when the abnormality has occurred in the battery system; and an instruction to detect a specific battery in which the abnormality has occurred based on temperatures of a plurality of batteries in the specific battery group.

## Description

### [Technical Field]

This application claims priority to and the benefit of Korean Patent Application No.10-2023-0144293 filed in the Korean Intellectual Property Office on October 26,2023 the entire contents of which are incorporated herein by reference.

The present invention relates to a battery management apparatus and method, and more particularly, to a battery management apparatus and method for detecting a specific battery in which an abnormality has occurred in a battery system including a plurality of battery groups.

### [Background Art]

As depletion of fossil fuels proceeds and interest in environmental pollution increases, a demand for secondary batteries as an eco-friendly alternative energy source is rapidly increasing. Among various alternative energy sources, demand for rechargeable lithium secondary batteries is rapidly increasing.

In general, in the case of electric vehicles or electric scooters, a number of batteries connected in parallel are grouped and used to configure a battery system.

For electric vehicles or electric scooters, long-term cycle operation is required to secure a driving distance, but which are exposed to various voltage and temperature conditions.

Accordingly, a sudden voltage drop occurs in the battery, which accelerates deterioration or an open circuit occurs in the battery due to overheating, causing the operation of the battery system to stop.

Here, in order to detect a battery with an abnormality in the battery system, the battery system needs to be disassembled and each battery therein should be inspected for abnormalities, which causes a disadvantage of a long time for analysis.

### [Detailed Description of the Invention]

### [Technical Problem]

To obviate one or more problems of the related art, embodiments of the present disclosure provide a battery management apparatus.

To obviate one or more problems of the related art, embodiments of the present disclosure also provide a battery management method.

### [Technical Solution]

In order to achieve the objective of the present disclosure, a battery management apparatus, located in a battery system including a plurality of battery groups, may include at least one processor; and a memory configured to store at least one instruction executed by the at least one processor, wherein the at least one instruction may include an instruction to detect occurrence of an abnormality in the battery system; an instruction to determine a specific battery group in which the abnormality has occurred depending on whether balancing has been performed when the abnormality has occurred in the battery system; and an instruction to detect a specific battery in which the abnormality has occurred based on temperatures of a plurality of batteries in the specific battery group.

The instruction to detect occurrence of an abnormality in the battery system may include an instruction to compare discharge time of the battery system with a previous discharge time; and an instruction to determine that an abnormality has occurred in the battery system when the discharge time and the previous discharge time differ by a predetermined threshold time or more.

The discharge time may be a duration of time consumed for a fully charged battery system to be completely discharged.

The instruction to determine the specific battery group may include an instruction to detect a specific battery group that satisfies a balancing performing condition more than a predetermined threshold number of times during charging and discharging of the battery system.

The instruction to detect the specific battery may include an instruction to measure temperatures of a plurality of batteries in the specific battery group; and an instruction to detect a battery cell having the lowest temperature among the plurality of batteries as the specific battery in which the abnormality has occurred.

The instruction to measure the temperatures of the plurality of batteries in the specific battery group may include an instruction to measure the temperatures of the plurality of batteries when the battery system is in a discharge state.

The at least one instruction may further include an instruction to determine a cause of failure of the specific battery based on the temperatures of a plurality of batteries in the specific battery group.

According to an embodiment, the instruction to determine the cause of failure of the specific battery may include an instruction to determine that an open circuit has occurred in the specific battery if the temperature data measured over time of the specific battery is within a first range that has been predefined.

According to another embodiment, the instruction to determine the cause of failure of the specific battery may include an instruction to determine that deterioration has occurred in the specific battery if the temperature data measured over time of the specific battery is within a second range that has been predefined.

According to another embodiment of the present disclosure, a battery management method, performed by a battery management apparatus located in a battery system including a plurality of battery groups, may include a step of detecting occurrence of an abnormality in the battery system; a step of determining a specific battery group in which the abnormality has occurred depending on whether balancing has been performed when the abnormality has occurred in the battery system; and a step of detecting a specific battery in which the abnormality has occurred based on temperatures of a plurality of batteries in the specific battery group.

The step of detecting occurrence of an abnormality in the battery system may include a step of comparing discharge time of the battery system with a previous discharge time; and a step of determining that an abnormality has occurred in the battery system when the discharge time and the previous discharge time differ by a predetermined threshold time or more.

The discharge time may be a duration of time consumed for a fully charged battery system to be completely discharged.

The step of determining the specific battery group may include a step of detecting a specific battery group that satisfies a balancing performing condition more than a predetermined threshold number of times during charging and discharging of the battery system.

The step of detecting the specific battery may include a step of measuring temperatures of a plurality of batteries in the specific battery group; and a step of detecting a battery cell having the lowest temperature among the plurality of batteries as the specific battery in which the abnormality has occurred.

The step of measuring temperatures of a plurality of batteries in the specific battery group may include a step of measuring the temperatures of the plurality of batteries when the battery system is in a discharge state.

The battery management method may further include a step of determining a cause of failure of the specific battery based on the temperatures of a plurality of batteries in the specific battery group.

The step of determining the cause of failure of the specific battery may include a step of determining that an open circuit has occurred in the specific battery if the temperature data measured over time of the specific battery is within a first range that has been predefined.

The step of determining the cause of failure of the specific battery may include a step of determining that deterioration has occurred in the specific battery if the temperature data measured over time of the specific battery is within a second range that has been predefined.

### [Advantageous Effects]

The battery management apparatus and method according to the embodiments and experimental examples of the present invention can detect a battery in which an abnormality has occurred in a battery system including a plurality of battery groups.

### [Brief Description of the Drawings]

FIG.1 is a block diagram of a battery system to which embodiments of the present invention may be applied.
FIG. 2 is a circuit diagram of a battery system according to an embodiment of the present invention.
FIG. 3 is a circuit diagram of a battery system according to another embodiment of the present invention.
FIG. 4 is a block diagram of a battery management apparatus according to embodiments of the present invention.
FIG. 5 is a flowchart for explaining a battery management method according to embodiments of the present invention.
FIG. 6 is a flowchart for explaining the step of detecting abnormality occurrence in a battery system of the battery management method according to embodiments of the present invention.
FIG. 7 is a discharge voltage graph of a plurality of battery groups according to an experimental example of the present invention.
FIG. 8 is a flowchart explaining a step of detecting a specific battery group of the battery management method according to embodiments of the present invention.
FIG. 9 is a graph of charge voltages of a plurality of battery groups according to an experimental example of the present invention.
FIG.10 is a flowchart for explaining a step of detecting a specific battery of the battery management methods according to embodiments of the present invention.
FIG. 11 shows a table that organizes temperature measurement data of batteries in a specific battery group measured using the battery system of FIG. 2 according to an experimental example of the present invention.
FIG. 12 shows a table that organizes temperature measurement data of heat sinks measured using the battery system of FIG. 3 according to an experimental example of the present invention.
FIG. 13 shows a graph of temperature measurement data of the heat sinks in FIG. 12 over time.
FIG. 14 shows a table summarizing temperature measurement data of batteries in the specific battery group measured using the battery system of FIG. 2 according to another experimental example of the present invention.
FIG. 15 shows a table summarizing temperature measurement data of heat sinks measured using the battery system of FIG. 3 according to another experimental example of the present invention.
FIG. 16 is a graph of temperature measurement data of the heat sinks over time in FIG. 15.
FIG. 17 is an image for explaining a shock test to which a battery management method according to embodiments of the present invention is applied.
FIG. 18 is an image for explaining a long-term charge/discharge experiment to which a battery management method according to embodiments of the present invention is applied.

100: battery system 110: battery group
111: battery 120: battery management apparatus
121: memory 122: processor
123: transceiver 124: input interface device
125: output interface device 126: storage device
127: bus 130: temperature sensor
140: heat sink

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it may be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, preferred embodiments according to the present invention will be described in detail with reference to the accompanying drawings.

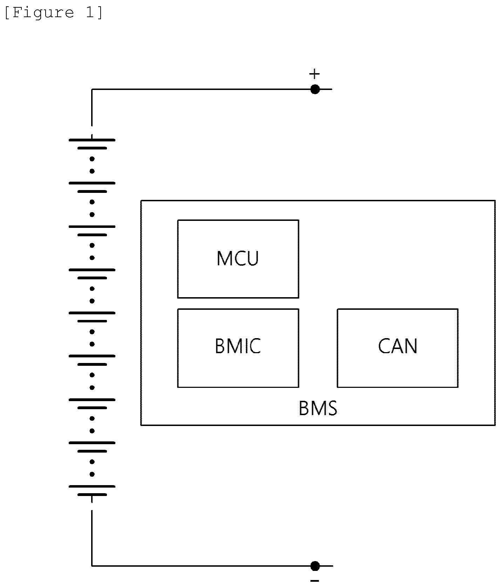

FIG.1 is a block diagram of a battery system to which embodiments of the present invention may be applied.

Referring to FIG. 1, a battery pack or battery module may include a plurality of battery cells connected in series. The battery pack or module may be connected to a load through a positive terminal and a negative terminal to perform charging or discharging. The most commonly used battery cell is a lithium-ion (Li-Ion) battery cell.

A battery management system (BMS) may be connected to a battery module or battery pack.

The battery management system may monitor a current, a voltage and a temperature of each battery cell or module to be managed, calculate state of charge (SOC) of the battery based on monitoring results to control charging and discharging. Here, the State of Charge (SOC) refers to a current state of charge of a battery, represented in percent points [%], and the State of Health (SOH) may be a current condition of a battery compared to its ideal conditions, represented in percent points [%].

The battery management system (BMS) may monitor battery cells, read cell voltages, and transmit them to other systems connected to the battery.

Furthermore, the battery management system (BMS) monitors at least one electrical component constituting the battery system and passes their status data to other systems. For this, the battery management system (BMS) includes a communication module for communicating with other systems in a device including the battery system.

The communication module of the battery management system (BMS) may communicate with other systems in the device using Controller Area Network (CAN). Here, components, modules or systems in the battery management system (BMS) are connected to each other through a CAN bus. Accordingly, the battery management system (BMS) may use CAN communication to remotely transmit status data obtained through monitoring of the battery pack or module and at least one electrical component constituting the battery management system (BMS) to other systems.

Meanwhile, the battery management system (BMS) may equally balance charges of the battery cells in order to extend the life of the battery system.

The battery management system (BMS) may include various components such as a fuse, a current sensing element, a thermistor, a switch, and a balancer to perform such operations. In most cases, a micro controller unit (MCU) or a battery monitoring integrated chip (BMIC) for interworking and controlling these components is additionally included in the BMS.

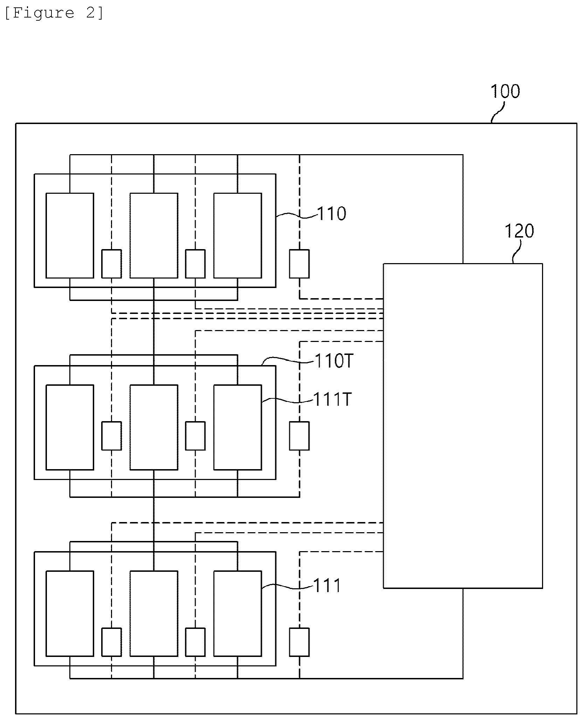

FIG. 2 is a circuit diagram of a battery system according to an embodiment of the present invention.

Referring to FIG. 2, the battery system 100 may include a plurality of battery groups 110, a battery management apparatus 120, and a plurality of temperature sensors 130.

The battery system 100 may be provided in a structure in which a plurality of battery groups 110 are connected in series.

Here, the plurality of battery groups 110 may be provided in a structure in which a plurality of batteries 111 are connected in parallel. In other words, the plurality of battery groups 110 may be provided in a structure in which a plurality of batteries 111 are connected in series and in parallel. For example, the battery system 100 may be provided with three battery groups 110 connected in series, wherein each of the battery groups may include three batteries connected in parallel.

Here, the battery may be a battery cell, and the battery group 110 may mean a battery module, a battery pack, or a battery rack, but the scope of the present invention is not limited to these entities. In addition, depending on the device or system in which the battery is used, the battery module may also be referred to as a battery bank. For example, the battery may be a battery bank.

The battery management apparatus 120 may be connected with each of a plurality of battery groups 110 that are connected in series. Accordingly, the battery management apparatus 120 may perform charging and discharging for the plurality of battery groups 110.

In addition, the battery management apparatus 120 may select a target battery group 110 that satisfies balancing requirement among the plurality of battery groups 110. Accordingly, balancing for the target battery group 110 may be performed.

In addition, the battery management apparatus 120 may detect a battery in which an abnormality has occurred in the plurality of battery groups 110. In other words, when an abnormality occurs in the battery system 100, the battery management apparatus 120 may detect a specific battery 111T in which an abnormality has occurred.

More specifically, when an abnormality occurs in the battery system 100, the battery management apparatus 120 may detect a specific battery group 110T that satisfies a balancing condition more than a predetermined number of times in the plurality of battery groups 110 as a battery group 110A in which an abnormality has occurred. Thereafter, the battery management apparatus 120 may measure temperatures of the multiple batteries 111 in the specific battery group 110A in which the abnormality has occurred and determine the battery with the lowest temperature value as the specific battery 111T in which the abnormality has occurred.

Here, according to an embodiment of the present invention, the temperatures of the plurality of batteries 111 may be individually measured by temperature sensors 130 individually connected to the plurality of batteries 111.

Meanwhile, according to another embodiment, the temperatures of the plurality of batteries 111 may be checked by measuring temperature of at least one heat sink positioned adjacent to or in contact with each of the plurality of batteries 111.

In addition, the battery management apparatus 120 may analyze a cause of failure of the specific battery 111T in which an abnormality has occurred.

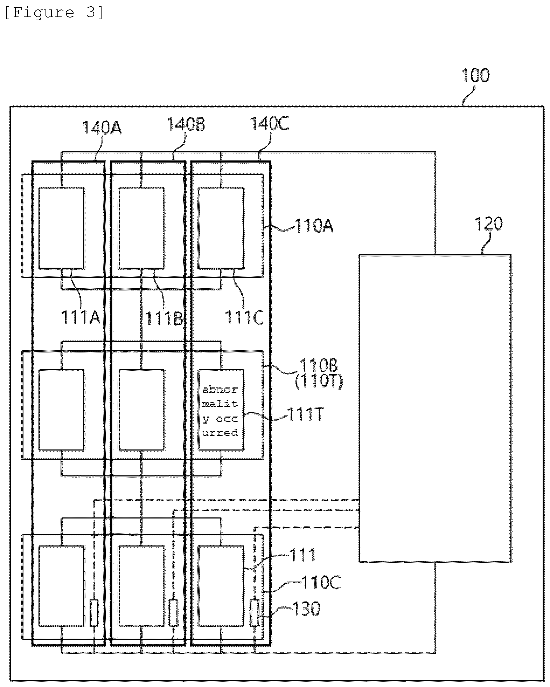

FIG. 3 is a circuit diagram of a battery system according to another embodiment of the present invention.

Referring to FIG. 3, the battery system 100 may further include a plurality of heat sinks 140.

According to embodiments, the heat sink 140 may be provided as a metal body. In addition, the heat sink 140 may be positioned adjacent to at least one battery 111, or may have at least one area in contact with the battery. Accordingly, the battery management apparatus 120 may infer the equilibrium temperature of the at least one battery 111 by measuring temperature of the heat sink 140.

More specifically, according to embodiments, the heat sink 140 may be positioned adjacent to a plurality of batteries 111 arranged in the same column, for a plurality of battery groups 110 within the battery system 100, or may have at least one area in contact with the batteries.

In other words, the plurality of batteries 111 arranged in a matrix form within the battery system 100 may receive heat from the plurality of batteries 111 arranged in the same column by the plurality of heat sinks 140.

For example, more specifically, when the battery system 100 includes a first battery group 110A, a second battery group 110B, and a third battery group 110C connected in series, the first heat sink 140A may be arranged along the first column so as to be adjacent to or in contact with the first battery 111A of the first battery group 110A, the first battery 111A of the second battery group 110B, and the first battery 111A of the third battery group 110C.

In addition, the second heat sink 140B may be arranged along the second column so as to be adjacent to or in contact with the second battery 111B of the first battery group 110A, the second battery 111B of the second battery group 110B, and the second battery 111B of the third battery group 110C.

In addition, the third heat sink 140C may be arranged along the third column so as to be adjacent to or in contact with the third battery 111C of the first battery group 110A, the third battery 111C of the second battery group 110B, and the third battery 111C of the third battery group 110C.

Meanwhile, temperature sensors 130 may be individually connected to at least one area of each of the first to third heat sinks 140. Accordingly, the temperature sensors 130 may individually measure the temperatures of the first to third heat sinks 140.

Here, the temperature of the heat sink 140 may correspond to the equilibrium temperature of a plurality of batteries which are positioned adjacent to the heat sink 140 or positioned so that one side thereof is in contact with the heat sink 140.

For example, to explain in more detail, the temperature of the first heat sink 140A may be a temperature at which the temperature of the first battery 111A in the first battery group 110A, the temperature of the first battery 111A in the second battery group 110B, and the temperature of the first battery 111A in the third battery group 110C are equilibrated.

In addition, the temperature of the second heat sink 140B may be a temperature at which the temperature of the second battery 111B in the first battery group 110A, the temperature of the second battery 111B in the second battery group 110B, and the temperature of the second battery 111B in the third battery group 110C are equilibrated.

In addition, the temperature of the third heat sink 140C may be a temperature at which the temperature of the third battery 111C in the first battery group 110A, the temperature of the third battery 111C in the second battery group 110B, and the temperature of the third battery 111C in the third battery group 110C are equilibrated.

Accordingly, when a problem occurs in one of the plurality of batteries 111, the temperature of the heat sink 140 located adjacent to or in contact with the battery 111 may be lower than that of the other heat sinks 140.

Therefore, the battery management apparatus according to this embodiment of the present invention may detect a specific battery 111T in which a problem has occurred by measuring temperatures of the plurality of heat sinks 140 and predicting temperature of the batteries 111 in a specific battery group 110T.

Hereinafter, a battery management method for detecting a battery in which an abnormality has occurred and analyzing a cause thereof using a battery management apparatus according to embodiments of the present invention will be described in more detail.

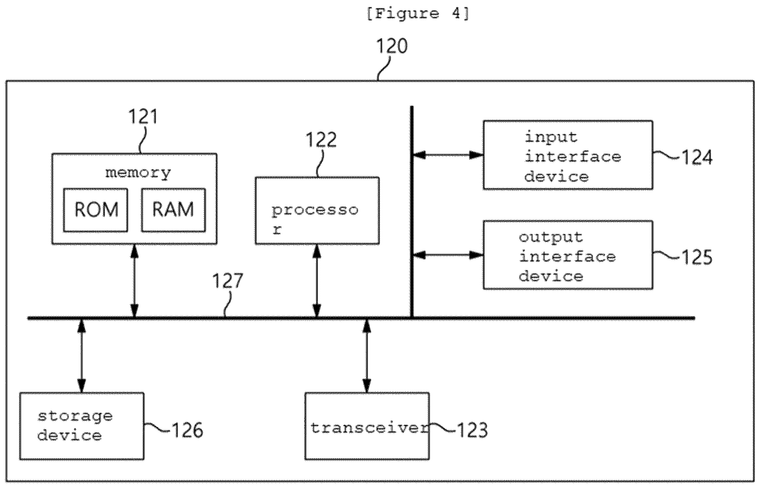

FIG. 4 is a block diagram of a battery management apparatus according to embodiments of the present invention.

Referring to FIG. 4, the battery management apparatus 120 may control balancing operations of a plurality of batteries. Here, the battery may be provided in the form of a battery cell or a battery assembly. Here, the battery assembly means an assembly that includes a plurality of electrically connected battery cells and functions as a power supply source when applied to a specific system or device.

Describing hardware configuration of the battery management apparatus 120 in more detail, the battery management apparatus 100 may include a memory 121, a processor 122, a transceiver 123, an input interface device 124, an output interface device 125, and a storage device 126.

According to embodiments, each of the components 121, 122, 123, 124, 125, 126 included in the battery management apparatus 120 may be connected by a bus 127 to communicate with each other.

Among the components 121, 122, 123, 124, 125, 126, the memory 121 and the storage device 160 may include at least one of a volatile storage medium and a nonvolatile storage medium. For example, the memory 121 and the storage device 126 may include at least one of a read only memory (ROM) and a random access memory (RAM).

Here, the memory 121 may include at least one instruction executed by the processor 122.

According to embodiments, the at least one instruction may include an instruction to detect occurrence of an abnormality in the battery system; an instruction to determine a specific battery group in which the abnormality has occurred depending on whether balancing has been performed when the abnormality has occurred in the battery system; and an instruction to detect a specific battery in which the abnormality has occurred based on temperatures of a plurality of batteries in the specific battery group.

Here, the instruction to detect occurrence of an abnormality in the battery system may include an instruction to compare discharge time of the battery system with a previous discharge time; and an instruction to determine that an abnormality has occurred in the battery system when the discharge time and the previous discharge time differ by a predetermined threshold time or more.

The discharge time may be a duration of time consumed for a fully charged battery system to be completely discharged.

Furthermore, the instruction to determine the specific battery group may include an instruction to detect a specific battery group that satisfies a balancing performing condition more than a predetermined threshold number of times during charging and discharging of the battery system.

In addition, the instruction to detect the specific battery may include an instruction to measure temperatures of a plurality of batteries in the specific battery group; and an instruction to detect a battery cell having the lowest temperature among the plurality of batteries as the specific battery in which the abnormality has occurred.

Here, the instruction to measure the temperatures of the plurality of batteries in the specific battery group may include an instruction to measure the temperatures of the plurality of batteries when the battery system is in a discharge state.

Meanwhile, the at least one instruction may further include an instruction to determine a cause of failure of the specific battery based on the temperatures of a plurality of batteries in the specific battery group.

According to an embodiment of the present invention, the instruction to determine the cause of failure of the specific battery may include an instruction to determine that an open circuit has occurred in the specific battery if the temperature data over time of the specific battery is within a first range that has been predefined.

According to another embodiment of the present invention, the instruction to determine the cause of failure of the specific battery may include an instruction to determine that deterioration has occurred in the specific battery if the temperature data over time of the specific battery is within a second range that has been predefined.

In addition, the memory 121 may store at least one piece of information, such as a time of occurrence of an abnormality in the battery system 100, information on a specific battery in which an abnormality occurred, and a cause of the failure, in real time. Accordingly, the processor 122 may transmit at least one piece of information to an administrator's terminal through the transceiver 123 on a request of the administrator.

The processor 122 may mean a central processing unit (CPU), a graphics processing unit (GPU), or a dedicated processor on which methods according to embodiments of the present invention are performed.

As described above, the processor 122 may execute at least one program command stored in the memory 121.

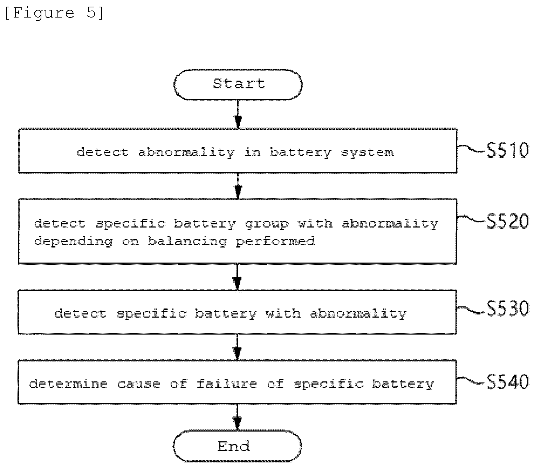

FIG. 5 is a flowchart for explaining a battery management method according to embodiments of the present invention.

Referring to FIG. 5, a processor 122 in a battery management apparatus 120 may detect an abnormality in a battery system 100 (S510).

Here, if an abnormality occurs in the battery system 100, the processor 122 may detect a specific battery group 110 in which an abnormality has occurred among a plurality of battery groups 110 depending on whether balancing has been performed (S520).

Thereafter, the processor 122 may detect a specific battery 111T in which an abnormality has occurred among a plurality of batteries 111 in the specific battery group 110 (S530).

According to an embodiment, the processor 122 may detect a specific battery 111T in which an abnormality has occurred based on temperatures of a plurality of batteries 111 in the specific battery group 110.

Afterwards, the processor 122 may determine a cause of failure of the specific battery 111T (S540).

According to embodiments, the processor 122 may determine a cause of failure of the specific battery 111T based on temperature measurement data of the specific battery 111T over time. For example, the processor 122 may determine the cause of failure due to open circuit or deterioration of the specific battery 111T.

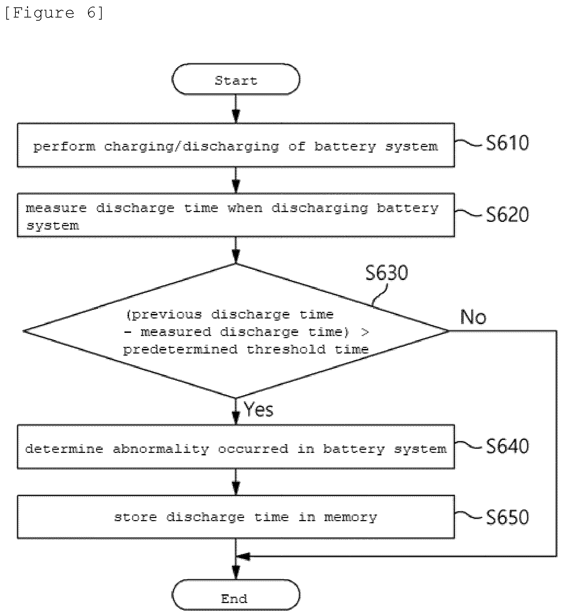

FIG. 6 is a flowchart for explaining the step of detecting abnormality occurrence in a battery system of the battery management method according to embodiments of the present invention.

Referring to FIG. 6, the processor 122 may perform charging and discharging of the battery system 100 (S610).

Thereafter, the processor 122 may measure discharge time when discharging the battery system 100 (S620). Here, the discharge time may be time required to completely discharge (State of Charge (SOC) 0%) the plurality of battery groups 110 that are fully charged (SOC 100%). In other words, the processor 122 may start discharging when the plurality of battery groups 110 are fully charged (SOC 100%) and measure the discharge time consumed until they are completely discharged (SOC 0%).

Thereafter, the processor 122 may compare the measured discharge time with a discharge time of the plurality of battery groups 110 measured previously (S630).

According to embodiments, if the discharge time and the previous discharge time differ by more than a predetermined threshold time, the processor 122 may determine that an abnormality has occurred in the battery system 100 (S640). For example, the predetermined threshold time may be 20 minutes. However, without being limited to the disclosed case, the predetermined threshold time may be determined based on discharge time of the battery system 100 in a normal state. In addition, the discharge time of the plurality of battery groups 110 measured previously may be the discharge time measured immediately before.

Generally, if an abnormality occurs in at least one battery 111 in the battery group 110, the specific battery 111 in which the abnormality occurred is not operating. Accordingly, the specific battery group 110 including the specific battery 111 may have a smaller charge capacity than that of a battery group 110 in which all batteries 111 are normally operating. Accordingly, as a result, the discharge time of a battery system 100 including the specific battery group 110 may be shortened compared to normal operation.

Thereafter, the processor 122 may store the discharge time in the memory 121 (S650).

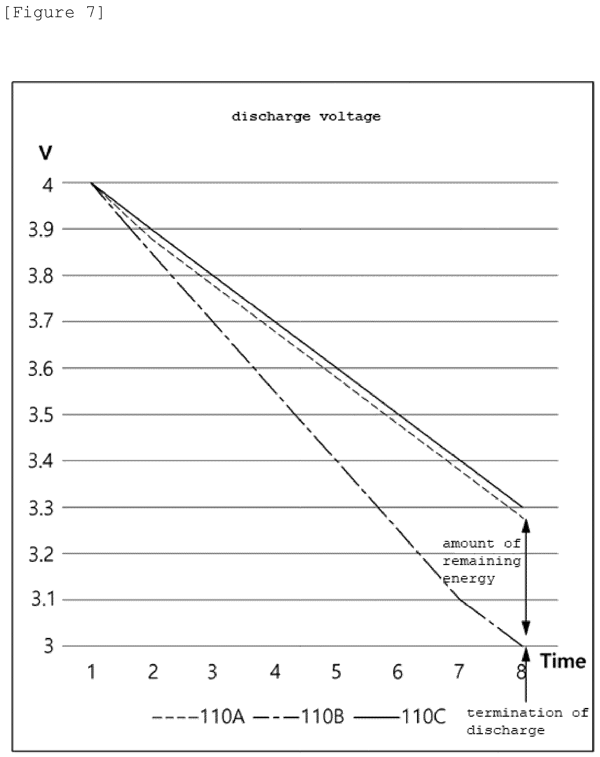

FIG. 7 is a discharge voltage graph of a plurality of battery groups according to an experimental example of the present invention.

Referring to FIG. 7, a battery system is prepared in which three battery groups including three parallel-connected batteries were connected in series. The discharge capacity of the battery system is 3Ah and the average discharge current is 1A.

Here, a battery with an abnormality is placed in the third column of the second battery group among the plurality of battery groups. Thereafter, when the battery system is discharged, the discharge time of the plurality of battery groups is measured.

As a result of the measurement, it can be understood that the discharge time of the battery system 110 changed from 3 hours to 2 hours, which is more than the predetermined threshold time.

Therefore, the battery management method according to the embodiments and experimental examples of the present invention may determine that an abnormality occurred in a specific battery in the battery system 100 based on the discharge time of the battery system.

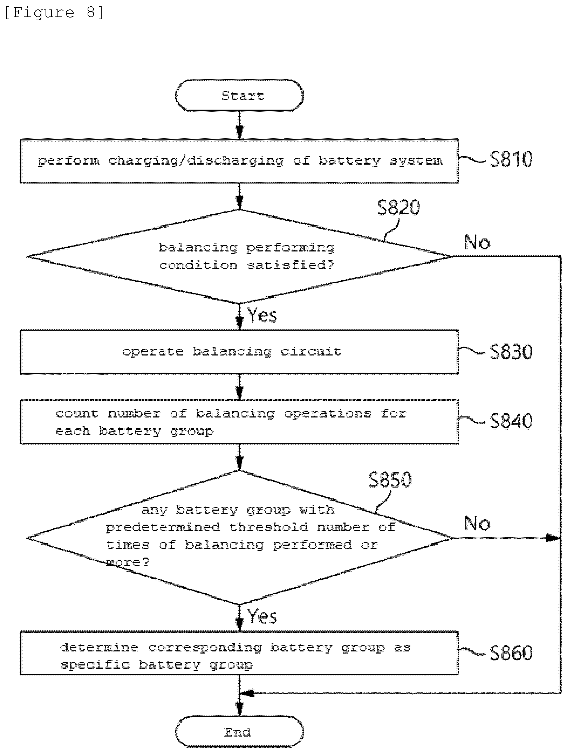

FIG. 8 is a flowchart explaining a step of detecting a specific battery group of the battery management method according to embodiments of the present invention.

Referring to FIG. 8, when the processor 122 performs charging and discharging of the battery system 100 (S810), if a plurality of battery groups 110 satisfies the balancing performing condition (S820), the processor 122 may operate the balancing circuit (S830). For example, the balancing performing condition may be a condition in which a voltage difference greater than a predetermined threshold value occurs compared to the battery group 110 with the lowest voltage measurement value by measuring voltages of a plurality of battery groups 110.

Thereafter, the processor 122 may count a number of balancing operations for each battery group 110 that satisfies the balancing performing condition and performs balancing (S840).

Thereafter, if there is a battery group 110 in which balancing has been performed more than a predefined threshold number of times (S850), the processor 122 may determine the battery group 110 as a specific battery group 110T in which an abnormality has occurred (S860).

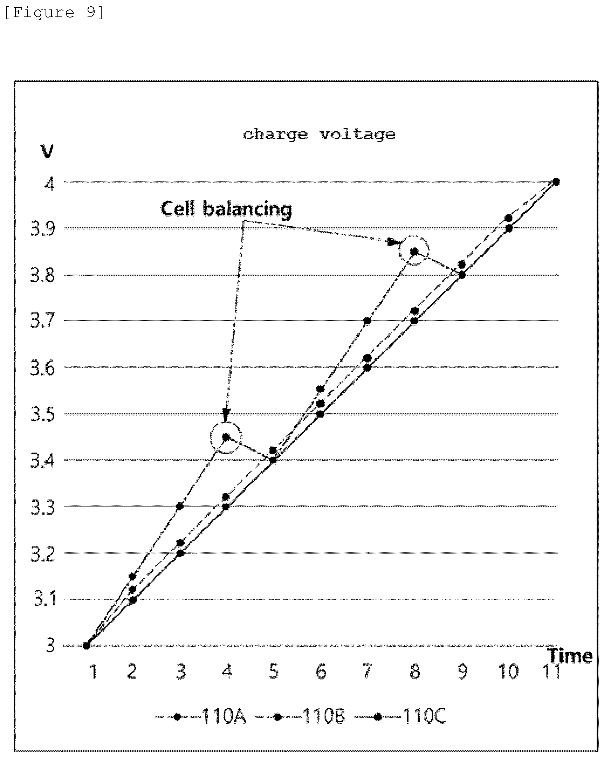

FIG. 9 is a graph of charge voltages of a plurality of battery groups according to an experimental example of the present invention.

Referring to FIG. 9, when charging a battery system 100, a charge current of the same size output from a charging circuit may be applied to a plurality of battery groups 110. Here, a battery group in which an abnormality has occurred among the plurality of battery groups 110 has a lower charge capacity than the battery groups 110 in a normal state, and thus may be charged at a faster rate. Accordingly, the voltage of the battery group 110 in which an abnormality has occurred increases compared to battery groups 110 in a normal state, and thus a voltage difference greater than a predetermined threshold value occurs among the plurality of battery groups 110, and thus the balancing performing condition may be satisfied. Accordingly, balancing may be performed so that the voltage of the battery group 110 in which an abnormality has occurred becomes the same as those of the battery groups 110 in a normal state. According to an embodiment, the balancing operation may be performed by discharging the battery group 110 in which an abnormality has occurred using a balancing resistor, thereby making the voltage magnitudes of the plurality of battery groups 110 the same.

Meanwhile, the balancing operation due to the difference in the charge capacity of the plurality of battery groups 110 may be repeatedly performed by the battery group 110 in which an abnormality has occurred. Therefore, the battery management method according to embodiments of the present invention may determine the battery group 110 that satisfies the balancing performing condition more than a predetermined threshold number of times as a specific battery group 110T in which an abnormality has occurred.

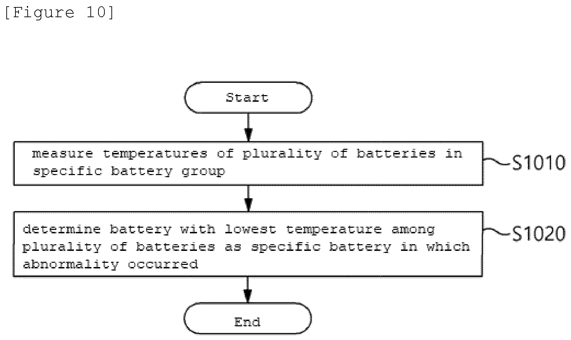

FIG.10 is a flowchart for explaining a step of detecting a specific battery of the battery management methods according to embodiments of the present invention.

Referring to FIG. 10, the processor 122 may measure temperatures of the plurality of batteries 111 in the specific battery group 110T (S1010).

According to an embodiment, the processor 122 may measure a temperature of each of the plurality of batteries 111 within the specific battery group 110T when discharging the battery system 100.

Thereafter, the processor 122 may determine the battery with the lowest temperature among the plurality of batteries 111 as the specific battery in which an abnormality has occurred (S1020).

More specifically, when the battery system 100 is being discharged, the batteries 111 in a normal state are discharged and heat may be generated due to internal resistance. Meanwhile, the battery in which an abnormality has occurred may not be discharged, and thus, the temperature of the battery may not change. Accordingly, the battery management method according to embodiments of the present invention may detect a specific battery 111T in which an abnormality has occurred by measuring temperatures of the batteries 111 within the specific battery group 110T in which an abnormality has been detected.

According to an embodiment, the processor 122 may measure temperatures of the batteries 111 using temperature sensors individually connected to the plurality of batteries 111, as in FIG. 2. Accordingly, the processor 122 may determine the battery with the lowest temperature as the specific battery in which an abnormality has occurred based on the temperatures of the individually measured batteries 111.

According to another embodiment, the processor 122 may measure the temperatures of the heat sinks 140 using temperature sensors connected to the heat sinks 140 as in FIG. 3. Accordingly, the processor 122 may detect the specific battery 111T in the specific battery group 110T adjacent to the heat sink 140 with the lowest temperature as the battery in which an abnormality has occurred based on the temperatures of the heat sinks 140.

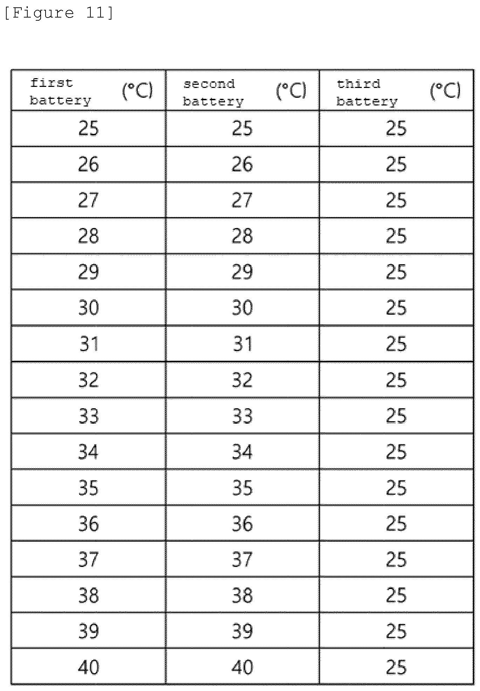

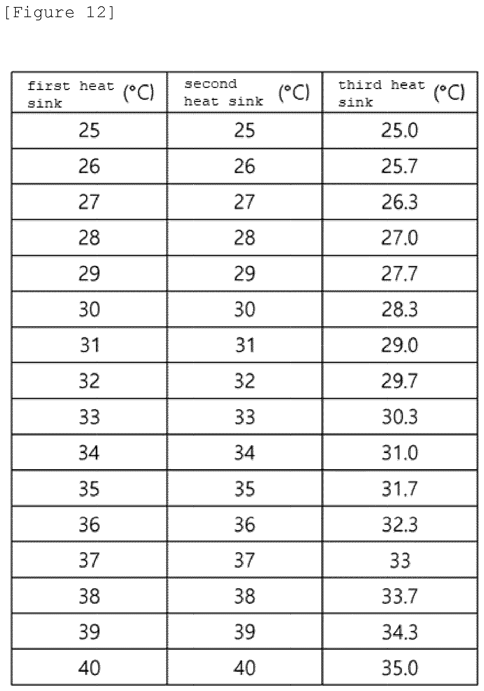

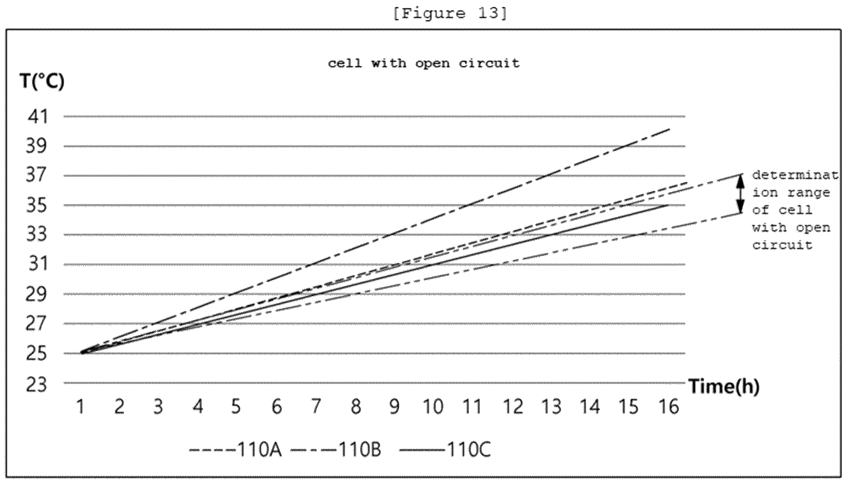

FIG. 11 shows a table that organizes temperature measurement data of batteries in a specific battery group measured using the battery system of FIG. 2 according to an experimental example of the present invention and FIG. 12 shows a table that organizes temperature measurement data of heat sinks measured using the battery system of FIG. 3 according to an experimental example of the present invention. In addition, FIG. 13 shows a graph of temperature measurement data of the heat sinks in FIG. 12 over time.

Referring to FIGS. 11 to 13, the processor 122 may determine a cause of the failure based on the temperature measurement data of the specific battery 111T measured over time.

According to an embodiment, the processor 122 may determine that an open circuit has occurred in the specific battery if the temperature measurement data obtained is within a first range defined in advance. Here, the first range may be defined based on temperature measurement data at the time of open circuit occurrence derived through a pre-test.

Generally, when a battery is open circuited, the temperature of the open circuited battery may be constant or within an error range. Accordingly, the first range may correspond to a measurement error range of a battery in which an open circuit has occurred.

Here, the temperature measurement data may be data measured through a temperature sensor individually connected to a specific battery 111T as in FIG. 11, or may be data obtained by measuring a temperature of a heat sink 140 positioned adjacent to the specific battery 111T or positioned with one side in contact with the specific battery as in FIG. 12.

According to the embodiments, when analyzing a cause of the failure using the temperature measurement data of the heat sink 140, the processor 122 may determine whether an open circuit has occurred in the specific battery by comparing a temperature measurement slope over time shown in the graph with a first range as in FIG. 13. The first range here may be defined as a range of a predetermined slope derived based on temperature measurement data at the time of an open circuit through a pre-test.

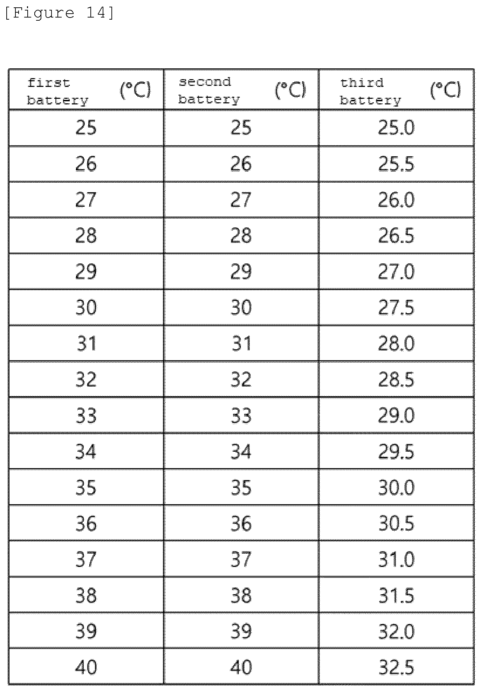

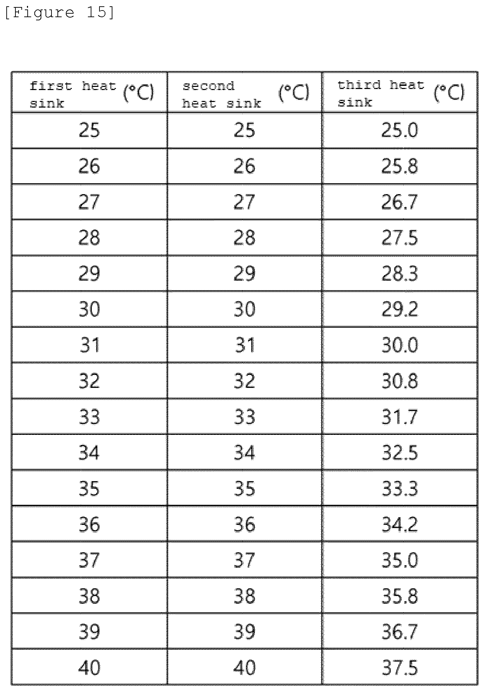

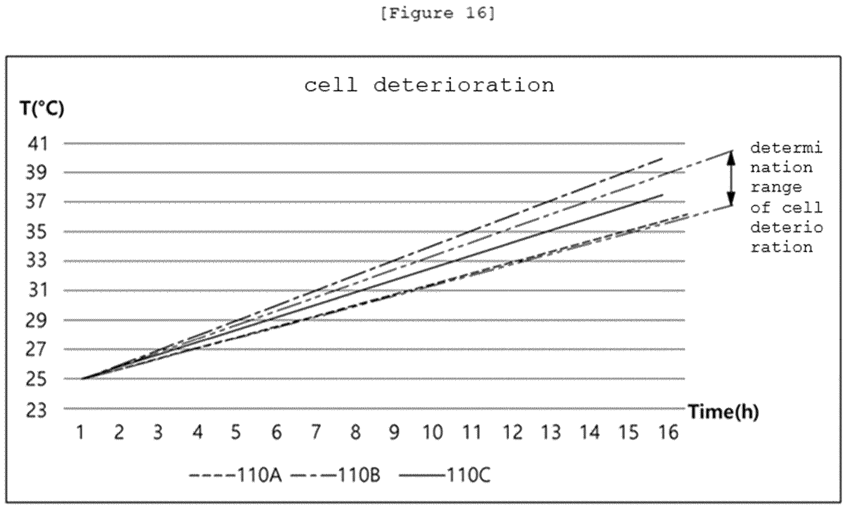

FIG. 14 shows a table summarizing temperature measurement data of batteries in the specific battery group measured using the battery system of FIG. 2 according to another experimental example of the present invention and FIG. 15 shows a table summarizing temperature measurement data of heat sinks measured using the battery system of FIG. 3 according to another experimental example of the present invention. In addition, FIG. 16 is a graph of temperature measurement data of the heat sinks over time in FIG. 15.

Referring to FIGS. 14 and 16, the processor 122 may determine that deterioration has occurred in the specific battery if the calculated temperature measurement data is within a predefined second range. According to an embodiment, the second range may be defined based on temperature measurement data at a time of battery deterioration derived through a pre-test.

Generally, when a battery deteriorates, internal resistance of the battery may increase. Accordingly, the size of discharge current in the battery may decrease. Accordingly, as the output power of the battery decreases, a temperature change may occur.

Accordingly, the battery management method according to this embodiment of the present invention and other embodiments may analyze a cause of failure due to open circuit or deterioration based on the temperature measurement data of the specific battery 111T.

According to the embodiment, the temperature measurement data may be data measured through a temperature sensor individually connected to the specific battery 111T as in FIG. 14, or may be data obtained by measuring temperature of the heat sink 140 positioned adjacent to the specific battery 111T or positioned with one side in contact with the specific battery as in FIG. 15.

Here, when analyzing the cause of failure using the temperature measurement data of the heat sink 140, the processor 122 may determine whether deterioration of the specific battery has occurred by comparing the temperature measurement slope over time shown on the graph with the second range as in FIG. 16. The second range here may be defined as a range of a predetermined slope derived based on the temperature measurement data at a time of battery deterioration through a pre-test.

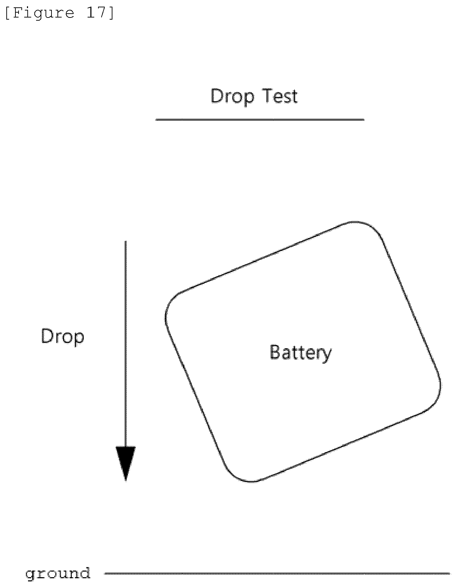

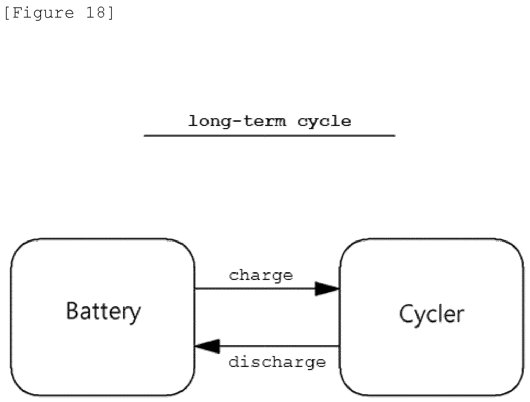

FIG. 17 is an image for explaining a shock test to which a battery management method according to embodiments of the present invention is applied and FIG. 18 is an image for explaining a long-term charge/discharge experiment to which a battery management method according to embodiments of the present invention is applied.

Referring to FIG. 17 and FIG. 18, a battery management method according to embodiments of the present invention may be applied to a reliability inspection process of a battery.

According to one embodiment, the battery management method may be applied to a shock test of a battery system.

More specifically, the battery management method according to embodiments of the present invention may obtain information on shock intensity vulnerable for the battery system and shock-vulnerable area of a battery system by checking whether at least one battery has an abnormality and a location of a specific battery where an abnormality has occurred, for a battery system where an shock experiment has been performed.

According to another embodiment, the battery management method may be applied to a long-term charge/discharge experiment of a battery system.

More specifically, the battery management method according to embodiments of the present invention may detect the time when an abnormality has occurred in at least one battery, for a battery system where a long-term charge/discharge experiment has been performed and recognize the specific time when aging is accelerated.

In other words, the battery management method according to embodiments of the present invention may be applied to a reliability inspection process of the battery system, thereby enabling manufacture of a battery system with high-performance and high-efficiency.

The battery management apparatus and method according to the embodiments and experimental examples of the present invention have been described above.

The battery management apparatus and method according to embodiments and experimental examples of the present invention may detect a battery in which an abnormality has occurred without separate disassembly of the battery system and analyze a cause of failure when an abnormality in a battery system including a plurality of battery groups is detected.

The operations of the method according to the embodiments and experimental examples of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that may be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery management apparatus located in a battery system including a plurality of battery groups, the apparatus comprising:
at least one processor; and
a memory configured to store at least one instruction executed by the at least one processor,
wherein the at least one instruction includes:
an instruction to detect occurrence of an abnormality in the battery system;
an instruction to determine a specific battery group in which the abnormality has occurred depending on whether balancing has been performed when the abnormality has occurred in the battery system; and
an instruction to detect a specific battery in which the abnormality has occurred based on temperatures of a plurality of batteries in the specific battery group.

2. The battery management apparatus of claim 1, wherein the instruction to detect occurrence of an abnormality in the battery system includes:
an instruction to compare discharge time of the battery system with a previous discharge time; and
an instruction to determine that an abnormality has occurred in the battery system when the discharge time and the previous discharge time differ by a predetermined threshold time or more.

3. The battery management apparatus of claim 2, wherein the discharge time is a duration of time consumed for a fully charged battery system to be completely discharged.

4. The battery management apparatus of claim 1, wherein the instruction to determine the specific battery group includes:
an instruction to detect a specific battery group that satisfies a balancing performing condition more than a predetermined threshold number of times during charging and discharging of the battery system.

5. The battery management apparatus of claim 1, wherein the instruction to detect the specific battery includes:
an instruction to measure temperatures of a plurality of batteries in the specific battery group; and
an instruction to detect a battery cell having the lowest temperature among the plurality of batteries as the specific battery in which the abnormality has occurred.

6. The battery management apparatus of claim 5, wherein the instruction to measure the temperatures of the plurality of batteries in the specific battery group includes:
an instruction to measure the temperatures of the plurality of batteries when the battery system is in a discharge state.

7. The battery management apparatus of claim 1, wherein the at least one instruction further includes:
an instruction to determine a cause of failure of the specific battery based on the temperatures of a plurality of batteries in the specific battery group.

8. The battery management apparatus of claim 7, wherein the instruction to determine the cause of failure of the specific battery includes:
an instruction to determine that an open circuit has occurred in the specific battery if the temperature data over time of the specific battery is within a first range that has been predefined.

9. The battery management apparatus of claim 7, wherein the instruction to determine the cause of failure of the specific battery includes:
an instruction to determine that deterioration has occurred in the specific battery if the temperature data over time of the specific battery is within a second range that has been predefined.

10. A battery management method performed by a battery management apparatus located in a battery system including a plurality of battery groups, the method comprising:
a step of detecting occurrence of an abnormality in the battery system;
a step of determining a specific battery group in which the abnormality has occurred depending on whether balancing has been performed when the abnormality has occurred in the battery system; and
a step of detecting a specific battery in which the abnormality has occurred based on temperatures of a plurality of batteries in the specific battery group.

11. The battery management method of claim 10, wherein the step of detecting occurrence of an abnormality in the battery system includes:
a step of comparing discharge time of the battery system with a previous discharge time; and
a step of determining that an abnormality has occurred in the battery system when the discharge time and the previous discharge time differ by a predetermined threshold time or more.

12. The battery management method of claim 11, wherein the discharge time is a duration of time consumed for a fully charged battery system to be completely discharged.

13. The battery management method of claim 10, wherein the step of determining the specific battery group includes:
a step of detecting a specific battery group that satisfies a balancing performing condition more than a predetermined threshold number of times during charging and discharging of the battery system.

14. The battery management method of claim 10, wherein the step of detecting the specific battery includes:
a step of measuring temperatures of a plurality of batteries in the specific battery group; and
a step of detecting a battery cell having the lowest temperature among the plurality of batteries as the specific battery in which the abnormality has occurred.

15. The battery management method of claim 14, wherein the step of measuring temperatures of a plurality of batteries in the specific battery group includes:
a step of measuring the temperatures of the plurality of batteries when the battery system is in a discharge state.

16. The battery management method of claim 10, further comprising:
a step of determining a cause of failure of the specific battery based on the temperatures of a plurality of batteries in the specific battery group.

17. The battery management method of claim 16, wherein the step of determining the cause of failure of the specific battery includes:
a step of determining that an open circuit has occurred in the specific battery if the temperature data over time of the specific battery is within a first range that has been predefined.

18. The battery management method of claim 16, wherein the step of determining the cause of failure of the specific battery includes:
a step of determining that deterioration has occurred in the specific battery if the temperature data over time of the specific battery is within a second range that has been predefined.
